# EUROPÄISCHE PATENTSCHRIFT

(11) **EP 4 241 093 B1**
(45) Veröffentlichungstag und Bekanntmachung des Hinweises auf die Patenterteilung: **24.07.2024**
(21) Anmeldenummer: 21806954.0
(22) Anmeldetag: 08.11.2021
(51) Int. Cl.: G01R 15/06, G01R 15/16, H01R 13/53

(54) **ANORDNUNG EINER MESSVORRICHTUNG**
MEASURING DEVICE ASSEMBLY
ENSEMBLE DISPOSITIF DE MESURE

(30) Priorität: 09.11.2020 AT 509612020
(43) Veröffentlichungstag der Anmeldung: 13.09.2023
(73) Patentinhaber: Greenwood-Power GmbH, 2471 Rohrau (AT)
(72) Erfinder: JUSCHICZ, Norbert, 2404 Petronell-Carnuntum (AT); BACHER, Willibald, 2404 Petronell-Carnuntum (AT)
(74) Vertreter: Puchberger & Partner Patentanwälte
(86) Internationale Anmeldenummer: PCT/AT2021/060415
(87) Internationale Veröffentlichungsnummer: WO 2022/094646

(56) Entgegenhaltungen:
- EP-A1- 0 087 267
- EP-A1- 0 911 936
- WO-A1-2020/011620
- CN-A- 105 044 428
- DE-A1- 102016 112 096
- DE-A1- 3 607 441
- US-A1- 2006 022 683
- US-A1- 2009 124 130
- US-A1- 2020 064 376

## Beschreibung

Die vorliegende Erfindung betrifft eine Anordnung eines T-förmigen Verbindungsstücks mit einer elektrischen Messvorrichtung.

Messvorrichtungen wie beispielsweise elektrische Spannungssensoren werden in elektrischen Mittel- und Hochspannungsleitungsnetzen eingesetzt, um kritische Parameter messen und kontrollieren zu können. Üblicherweise werden zur Einbindung der Messvorrichtungen in das Leitungsnetz sogenannte T-Konnektoren verwendet, die beispielsweise in Schalt- oder Verteilerkästen angeordnet sind.

Derartige T-Konnektoren umfassen einen Leitungseingang, einen Leitungsausgang, sowie eine Messbuchse. In einem Aufnahmebereich der Messbuchse ist ein elektrischer Spannungssensor platzierbar und mit der vom Leitungseingang zum Leitungsausgang verlaufenden elektrischen Leitung verbindbar. Derartige T-Konnektoren sind aus verschiedensten Druckschriften bekannt, beispielsweise aus US 2020/064376 A1, US 2006/022683 A1, DE 36 07 441 A1, EP 0 911 936 A1, CN 105 044 428 A1, DE 10 2016 112096 A1, US 2009/124130 A1, EP 0 087 267 A1, und aus WO 2020/011620 A1

Herstellerabhängig weisen die Messbuchsen unterschiedlicher T-Konnektoren verschiedene Geometrien auf, sodass eine Adaptierung der Geometrie der Messvorrichtung notwendig ist, um ein passgenaues Einführen der Messvorrichtung in die jeweilige Messbuchse zu erlauben.

Derartige Messbuchsen sind zwar meist konisch ausgeführt, die Aufnahmebereiche weisen jedoch insbesondere unterschiedliche Längen auf. Wenn Messvorrichtungen in eine unpassende Messbuchse eingeführt werden, können Spalten oder luftgefüllte Bereiche entstehen, die Spannungsüberschläge und Streukapazitäten begünstigen, was zu ungenauen Messungen führt.

Es wurde erkannt, dass derartige luftgefüllte Bereiche und Spalten zwischen der Messbuchse und der Messvorrichtung insbesondere bei Messvorrichtungen, die eine kapazitive Elektrodenanordnung umfassen, zu Problemen führen.

Es ist daher eine Aufgabe der vorliegenden Erfindung, eine Messvorrichtung zu schaffen, die flexibel mit Verbindungsstücken unterschiedlicher Geometrie verwendet werden kann. In Verbindung hiermit ist es eine weitere Aufgabe, eine Anordnung eines T-förmigen Verbindungsstücks mit einer Messvorrichtung zu schaffen, die das Auftreten von Störeinflüssen minimiert, obwohl zwischen der Messbuchse und der Messvorrichtung gegebenenfalls Spalten oder luftgefüllte Bereiche vorhanden sind. Die Messvorrichtung ist in Anspruch 11 definiert.

Die Erfindung betrifft, nach Anspruch 1, eine Anordnung eines T-förmigen Verbindungsstücks umfassend einer Leitungseingang, einen Leitungsausgang und eine Messbuchse, wobei in der Messbuchse die Messvorrichtung nach Anspruch 11, insbesondere ein elektrischer Spannungssensor, angeordnet ist, wobei die Messvorrichtung ein Koppelelement zur Verbindung der Messvorrichtung mit der Messbuchse, sowie eine Kondensatoranordnung mit zwei einander gegenüberliegenden Elektroden umfasst, wobei die erste Elektrode am Koppelelement angeordnet ist und wobei die zweite Elektrode an einem Erdungselement angeordnet ist, wobei die Messbuchse einen Aufnahmebereich mit einer Aufnahmebereichstiefe aufweist, und wobei die Messvorrichtung einen Einführbereich mit einer Einführbereichslänge aufweist, wobei die Aufnahmebereichstiefe kleiner oder gleich der Einführbereichslänge ist.

Erfindungsgemäß ist vorgesehen, dass sich die zweite Elektrode bis in den Aufnahmebereich der Messbuchse erstreckt. Die Erfinder haben überraschend festgestellt, dass hierdurch Streukapazitäten insbesondere in Fällen vermieden werden können, in denen zwischen der Messbuchse und der Messvorrichtung ein Spalt gebildet ist. Dieser Spalt kann insbesondere dadurch gebildet sein, dass der Aufnahmebereich der Messbuchse zu kurz ist und dadurch der korrespondierende Einführbereich der Messvorrichtung nicht vollständig in den Aufnahmebereich eingeführt werden kann. Im Bereich dieses Spalts überlappen sich die Elektroden.

Konventionelle Messvorrichtungen, bei denen die Elektrode nicht in den Aufnahmebereich ragt, hätten bei einer derartigen Anordnung das Problem, dass der zwischen der Messbuchse und der Messvorrichtung entstehende Spalt eine Streukapazität generieren würde, die die Messung in unkontrollierbarer Weise beeinflusst.

Durch die in den Einführbereich ragende zweite Elektrode wird dieser Spalt jedoch überbrückt und der Einfluss des Spalts wird reduziert oder sogar vollständig ausgeschlossen.

Es ist somit vorteilhaft, wenn die Einführbereichslänge groß genug ist, um in die Messbuchsen aller gängigen Verbindungsstücke vollständig eingeführt zu werden.

Gegebenenfalls ist vorgesehen, dass die äußeren Oberflächen des Aufnahmebereichs und des Einführbereichs im Wesentlichen gegengleich ausgeführt sind, sodass beim Einführen der Messvorrichtung in die Messbuchse der Einführbereich bündig und ohne Bildung von Zwischenräumen am Aufnahmebereich zu liegen kommt. Ein bündiges Anliegen der Messvorrichtung an der inneren Oberfläche der Messbuchse ist wichtig, um die Ausbildung von luftgefüllten Räumen oder Bereichen an den Kontaktflächen zu vermeiden. Gegebenenfalls kann die innere Oberfläche der Messbuche und/oder die äußere Oberfläche der Messvorrichtung ein elastisches Material umfassen, um ein bündiges Anliegen und eine bedingte Flexibilität zu gewährleisten.

Gegebenenfalls ist vorgesehen, dass der Aufnahmebereich und der Einführbereich kegelstumpfförmig ausgebildet sind.

Gegebenenfalls ist vorgesehen, dass der Einführbereich eine Länge von 5 cm bis 20 cm, insbesondere von 10 cm bis 15 cm, aufweist.

Gegebenenfalls ist vorgesehen, dass das Koppelelement mit einem Leitungselement des Verbindungsstücks in elektrisch leitender Verbindung steht. Vorzugsweise wird durch das Koppelelement die Verbindung mit dem zu messenden Leitungselement hergestellt. Diese Verbindung kann beispielsweise durch eine Schraubverbindung oder durch eine Steckverbindung hergestellt werden.

Gegebenenfalls ist vorgesehen, dass das Koppelelement mit dem Verbindungsstück, insbesondere mit dem Leitungselement, verschraubt ist.

Gegebenenfalls ist vorgesehen, dass die erste Elektrode und die zweite Elektrode über ein resistives Element, insbesondere ein Widerstandselement elektrisch leitend miteinander verbunden sind. Eine derartige Anordnung in Kombination mit einer kapazitiven Elektrodenanordnung ist insbesondere bei Ohmsch-kapazitiven Spannungsteilern vorgesehen, die zur Messung der Spannung von stromführenden Leitungen verwendet werden.

Erfindungsgemäß ist vorgesehen, dass die Elektroden stabförmige oder fingerförmige Aussteuerungselemente umfassen.

Erfindungsgemäß ist vorgesehen, dass jede Elektrode mehrere im Wesentlichen kreisförmig angeordnete Aussteuerungselemente umfasst, wobei die Aussteuerungselemente der Elektroden zueinander konzentrisch angeordnet sind, sich in entgegengesetzte Richtungen erstrecken und sich zumindest teilweise überlappen, nämlich vorzugsweise in einem Teil des Einführbereichs, der sich über den Aufnahmebereich hinaus erstreckt.

Gegebenenfalls ist vorgesehen, dass sich die zweite Elektrode wenigstens 0,5 cm weit, insbesondere wenigstens 1,0 cm weit, in den Aufnahmebereich erstreckt.

Gegebenenfalls ist vorgesehen, dass das Verbindungsstück ein elektrisch isolierendes Gehäuse umfasst, wobei der Aufnahmebereich einen Teil des Gehäuses bildet.

Ferner offenbart ist eine Messvorrichtung zu Verwendung in einer erfindungsgemäßen Anordnung. Die zweite Elektrode der Messvorrichtung erstreckt sich vorzugsweise in den Einführbereich der Messvorrichtung. Weiter bevorzugt erstreckt sich die zweite Elektrode wenigstens 1 cm weit in den Einführbereich.

Weitere Merkmale der Erfindung ergeben sich aus den Patentansprüchen, der Figur, sowie der Beschreibung des Ausführungsbeispiels.

Nachfolgend wird die vorliegende Erfindung anhand eines exemplarischen Ausführungsbeispiels im Detail erläutert.

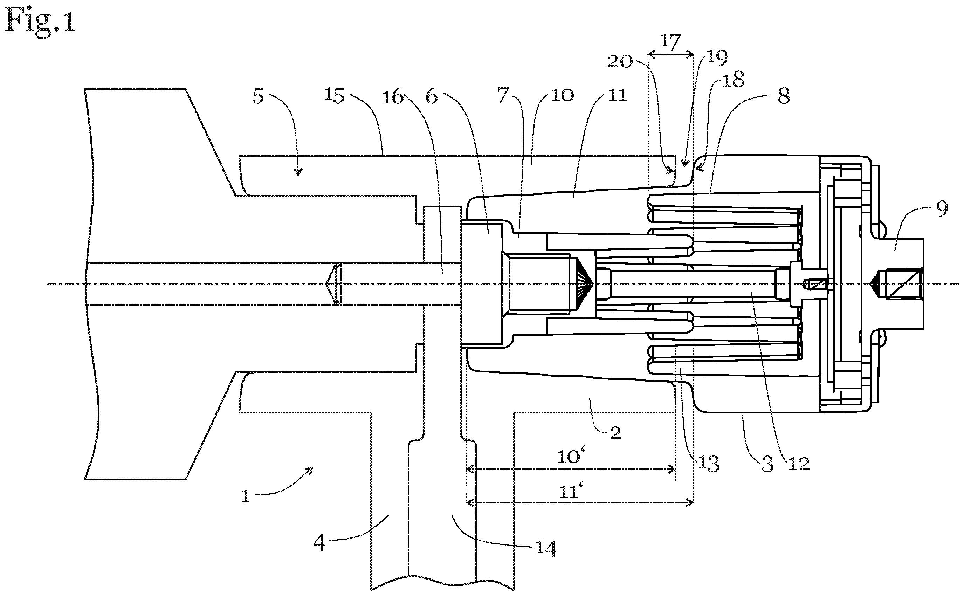

Fig. 1 zeigt eine schematische Schnittansicht einer erfindungsgemäßen Anordnung gemäß einem Ausführungsbeispiel der vorliegenden Erfindung.

Die erfindungsgemäße Anordnung umfasst ein Verbindungsstück 1, sowie eine Messvorrichtung 3. Das Verbindungsstück 1 ist als T-förmiges Verbindungsstück 1 ausgeführt und es umfasst einen Leitungseingang 4, einen Leitungsausgang 5, sowie eine Messbuchse 2. Innerhalb des Gehäuses 15, das aus elektrisch isolierendem Kunststoff gebildet ist, ist ein Leitungselement 14 angeordnet, welches mit einem elektrischen Stromnetz in Verbindung steht. Im Bereich der Messbuchse 2 verfügt das Leitungselement 14 zur Verbindung mit der Messvorrichtung 3 über einen Schraubanschluss 16.

Die Messbuchse 2 umfasst einen kegelstumpfförmigen Aufnahmebereich 10 mit einer Aufnahmebereichstiefe 10', die sich im Wesentlichen vom Öffnungsbereich 20 des Aufnahmebereichs 10 zum Leitungselement 14 erstreckt.

Die Messvorrichtung 3 ist in diesem Ausführungsbeispiel ein Ohmsch-kapazitiver Spannungsteiler, der zur Messung der Spannung im Leitungselement 14 ausgeführt ist. Die Messvorrichtung 3 umfasst eine erste Elektrode 7 und eine zweite Elektrode 8. An der ersten Elektrode 7 ist ein Koppelelement 6 angeordnet, welches zur Verbindung mit dem Leitungselement 14 ausgeführt ist. An der zweiten Elektrode 8 ist ein Erdungselement 9 angeordnet, welches der Verbindung mit einer nicht dargestellten Erdung dient. Das Abgreifen des Messsignals erfolgt auf der Seite des Erdungselements 9.

Die beiden Elektroden 7, 8 umfassen fingerförmige Aussteuerungselemente 13, wobei die Aussteuerungselemente 13 jeder Elektrode 7, 8 ringförmig angeordnet sind. Die Aussteuerungselemente 13 der Elektroden 7, 8 weisen entlang ihrer Längserstreckung einen Überlappungsbereich 17 auf. Die Elektroden 7, 8 sind durch ein hochohmiges Widerstandselement 12 elektrisch leitend miteinander verbunden.

Der Einführbereich 11 der Messvorrichtung 3 weist eine kegelstumpfförmige Mantelfläche auf, deren Geometrie an die Form des Aufnahmebereichs 10 angepasst ist. Insbesondere die Neigungen der Kontaktflächen des Aufnahmebereichs 10 und des Einführbereichs 11 sind aneinander angepasst, um eine bündige Anlage zu gewährleisten und die Bildung von Hohlräumen zu vermeiden.

Der Einführbereich 11 weist eine Einführbereichslänge 11' auf, die sich im Wesentlichen vom Koppelelement 6 bis zu einem Anschlag in Form einer umlaufenden verbreiternden Stufe 18 am Ende des Einführbereichs 11 erstreckt. Die Einführbereichslänge 11' ist größer als die Aufnahmebereichstiefe 10', sodass zwischen dem Öffnungsbereich 20 des Aufnahmebereichs 10 und der Stufe 18 der Messvorrichtung 3 ein Spalt 19 gebildet ist. Vorzugsweise ist die Einführbereichslänge 11' der Messvorrichtung 3 so angepasst, dass sie bei unterschiedlichen Ausführungen des Verbindungsstücks 1 größer oder gleich der jeweiligen Aufnahmebereichstiefe 10' ist, um eine Ausführung der Messvorrichtung 3 an unterschiedlichen Verbindungsstücken 1 einsetzen zu können.

Die Aussteuerungselemente 13 der zweiten Elektrode 8 erstrecken sich bis in den Aufnahmebereich 10 der Messbuchse 2, sodass die Aussteuerungselemente 13 der zweiten Elektrode 8 den Spalt 19 überbrücken. Dadurch wird das Auftreten von durch den Spalt 19 hervorgerufenen Streukapazitäten verhindert.

In diesem Ausführungsbeispiel erstreckt sich die zweite Elektrode 8, insbesondere deren Aussteuerungselemente 13, etwa 2 cm weit in den Einführbereich 11 der Messvorrichtung 3. Hierdurch ist es bei den meisten am Markt verfügbaren Verbindungsstücken möglich, dass sich die zweite Elektrode 8 in den Aufnahmebereich 10 der Messbuchse 2 erstreckt.

In alternativen nicht gezeigten und nicht beanspruchten Ausführungsformen können die Elektroden 7, 8 auch als plattenförmige oder ringförmige Elektroden ausgeführt sein.

### Bezugszeichenliste

- 1: Verbindungsstück
- 2: Messbuchse
- 3: Messvorrichtung
- 4: Leitungseingang
- 5: Leitungsausgang
- 6: Koppelelement
- 7: erste Elektrode
- 8: zweite Elektrode
- 9: Erdungselement
- 10: Aufnahmebereich
- 10': Aufnahmebereichstiefe
- 11: Einführbereich
- 11': Einführbereichstiefe
- 12: Widerstandselement
- 13: Aussteuerungselement
- 14: Leitungselement
- 15: Gehäuse
- 16: Schraubanschluss
- 17: Überlappungsbereich
- 18: Stufe
- 19: Spalt
- 20: Öffnungsbereich

## Patentansprüche

1. **Anordnung** eines T-förmigen Verbindungsstücks (1) umfassend einen Leitungseingang (4), einen Leitungsausgang (5) und eine Messbuchse (2), wobei in der Messbuchse (2) eine Messvorrichtung (3), insbesondere ein elektrischer Spannungssensor, angeordnet ist, wobei die Messbuchse (2) einen Aufnahmebereich (10) mit einer Aufnahmebereichstiefe (10`) aufweist,
**dadurch gekennzeichnet, dass**
- die Messvorrichtung (3) gemäß Anspruch 11 ausgebildet ist, wobei
- die Aufnahmebereichstiefe (10') kleiner oder gleich der Einführbereichslänge (11') der Messvorrichtung (3) ist, und
- sich die zweite Elektrode (8) der Messvorrichtung (3) bis in den Aufnahmebereich (10) der Messbuchse (2) erstreckt.

2. Anordnung nach Anspruch 1, **dadurch gekennzeichnet, dass** die äußeren Oberflächen des Aufnahmebereichs (10) und des Einführbereichs (11) im Wesentlichen gegengleich ausgeführt sind, sodass beim Einführen der Messvorrichtung (3) in die Messbuchse (2) der Einführbereich (11) bündig und ohne Bildung von Zwischenräumen am Aufnahmebereich (10) zu liegen kommt.

3. Anordnung nach Anspruch 2, **dadurch gekennzeichnet, dass** der Aufnahmebereich (10) und der Einführbereich (11) kegelstumpfförmig ausgebildet sind.

4. Anordnung nach einem der Ansprüche 1 bis 3, **dadurch gekennzeichnet, dass** der Einführbereich (11) eine Länge von 5 cm bis 20 cm, insbesondere von 10 cm bis 15 cm, aufweist.

5. Anordnung nach einem der Ansprüche 1 bis 4, **dadurch gekennzeichnet, dass** das Koppelelement (6) mit einem Leitungselement (14) des Verbindungsstücks in elektrisch leitender Verbindung steht.

6. Anordnung nach einem der Ansprüche 1 bis 5, **dadurch gekennzeichnet, dass** das Koppelelement (6) mit dem Verbindungsstück (1), insbesondere mit dem Leitungselement (14), verschraubt ist.

7. Anordnung nach einem der Ansprüche 1 bis 6, **dadurch gekennzeichnet, dass** die erste Elektrode (7) und die zweite Elektrode (8) über ein resistives Element, insbesondere ein Widerstandselement (12) elektrisch leitend miteinander verbunden sind.

8. Anordnung nach einem der Ansprüche 1 bis 7, **dadurch gekennzeichnet, dass** jede Elektrode (7, 8) mehrere im Wesentlichen kreisförmig angeordnete Aussteuerungselemente (13) umfasst, wobei die Aussteuerungselemente (13) der Elektroden (7, 8) zueinander konzentrisch angeordnet sind, sich in entgegengesetzte Richtungen erstrecken und sich zumindest teilweise überlappen, nämlich vorzugsweise in einem Teil des Einführbereichs (11), der sich über den Aufnahmebereich (10) hinaus erstreckt.

9. Anordnung nach einem der Ansprüche 1 bis 8, **dadurch gekennzeichnet, dass** sich die zweite Elektrode (8) wenigstens 0,5 cm weit, insbesondere wenigstens 1,0 cm weit, in den Aufnahmebereich (10) erstreckt.

10. Anordnung nach einem der Ansprüche 1 bis 9, **dadurch gekennzeichnet, dass** das Verbindungsstück (1) ein elektrisch isolierendes Gehäuse (15) umfasst, wobei der Aufnahmebereich (10) einen Teil des Gehäuses (15) bildet.

11. Messvorrichtung (3) insbesondere elektrischer Spannungssensor, wobei
- die Messvorrichtung (3) ein Koppelelement (6) zur Verbindung der Messvorrichtung (3) mit einer Messbuchse (2) eines T-förmigen Verbindungsstücks (1 sowie eine Kondensatoranordnung mit zwei einander gegenüberliegenden Elektroden (7, 8) umfasst, wobei die erste Elektrode (7) am Koppelelement (6) angeordnet ist und wobei die zweite Elektrode (8) an einem Erdungselement (9) angeordnet ist, und wobei die Elektroden (7, 8) stabförmige oder fingerförmige Aussteuerungselemente (13) umfassen, und wobei
- die Messvorrichtung (3) einen Einführbereich (11) mit einer Einführbereichslänge (11') aufweist,
**dadurch gekennzeichnet, dass**
- der Einführbereich (11) sich vom Koppelelement (6) bis zu einer umlaufenden verbreiternden Stufe (18) erstreckt, wobei
- die Elektroden (7, 8) einen Überlappungsbereich (17) bilden, der sich ebenfalls bis zu der Stufe (18) erstreckt, und in welchem sich die Elektroden (7, 8) überlappen.

## Claims

1. An **arrangement** of a T-shaped connector (1) comprising a line input (4), a line output (5) and a measuring socket (2), wherein a measuring device (3), in particular an electrical voltage sensor, is arranged in the measuring socket (2), wherein the measuring socket (2) has a receiving area (10) with a receiving area depth (10'),
**characterised in that**
- the measuring device (3) is configured according to claim 11, wherein
- the receiving area depth (10') is smaller than or equal to the insertion area length (11') of the measuring device (3), and
- the second electrode (8) of the measuring device (3) extends into the receiving area (10) of the measuring socket (2).

2. The arrangement according to claim 1, **characterised in that** the outer surfaces of the receiving area (10) and of the insertion area (11) are designed to be substantially opposite, so that when the measuring device (3) is inserted into the measuring socket (2), the insertion area (11) rests flush against the receiving area (10) without forming any gaps.

3. The arrangement according to claim 2, **characterised in that** the receiving area (10) and the insertion area (11) are frustoconically shaped.

4. The arrangement according to one of claims 1 to 3, **characterised in that** the insertion area (11) has a length of 5 cm to 20 cm, in particular of 10 cm to 15 cm.

5. The arrangement according to one of claims 1 to 4, **characterised in that** the coupling element (6) is in electrically conductive connection with a line element (14) of the connector.

6. The arrangement according to one of claims 1 to 5, **characterised in that** the coupling element (6) is screwed to the connector (1), in particular to the line element (14).

7. The arrangement according to one of claims 1 to 6, **characterised in that** the first electrode (7) and the second electrode (8) are connected to each other in an electrically conductive manner via a resistive element, in particular a resistance element (12).

8. The arrangement according to one of claims 1 to 7, **characterised in that** each electrode (7, 8) comprises a plurality of substantially circularly arranged modulating elements (13), wherein the modulating elements (13) of the electrodes (7, 8) are arranged concentrically to each other, extend in opposite directions and at least partially overlap, namely preferably in a part of the insertion area (11), which extends beyond the receiving area (10).

9. The arrangement according to one of claims 1 to 8, **characterised in that** the second electrode (8) extends at least 0.5 cm, in particular at least 1.0 cm, into the receiving area (10).

10. The arrangement according to one of claims 1 to 9, **characterised in that** the connector (1) comprises an electrically insulating housing (15), the receiving area (10) forming part of the housing (15).

11. A measuring device (3), in particular an electrical voltage sensor, wherein
- the measuring device (3) comprises a coupling element (6) for connecting the measuring device (3) to a measuring socket (2) of a T-shaped connector (1), as well as a capacitor arrangement with two electrodes (7, 8) facing each other, wherein the first electrode (7) is arranged on the coupling element (6) and wherein the second electrode (8) is arranged on a grounding element (9), and wherein the electrodes (7, 8) comprise rod-shaped or finger-shaped modulation elements (13), and wherein
- the measuring device (3) has an insertion area (11) with an insertion area length (11'),
**characterised in that**
- the insertion region (11) extends from the coupling element (6) to a peripheral widening step (18), wherein
- the electrodes (7, 8) form an overlapping region (17) which also extends to the step (18), and in which the electrodes (7, 8) overlap.

## Revendications

1. **Agencement** d'une pièce de connexion (1) en forme de T comprenant une entrée de ligne (4), une sortie de ligne (5) et une douille de mesure (2), dans lequel un dispositif de mesure (3), en particulier un capteur de tension électrique, est disposé dans la douille de mesure (2), dans lequel la douille de mesure (2) présente une zone de réception (10) avec une profondeur de zone de réception (10'),
**caractérisé en ce que**
- le dispositif de mesure (3) est réalisé selon la revendication 11, dans lequel
- la profondeur de la zone de réception (10') est inférieure ou égale à la longueur de zone d'introduction (1 1') du dispositif de mesure (3), et
- la deuxième électrode (8) du dispositif de mesure (3) s'étend jusque dans la zone de réception (10) de la douille de mesure (2).

2. Agencement selon la revendication 1, **caractérisé en ce que** les surfaces extérieures de la zone de réception (10) et de la zone d'introduction (11) sont réalisées substantiellement de manière opposée, de sorte que lors de l'introduction du dispositif de mesure (3) dans la douille de mesure (2), la zone d'introduction (11) vient se placer à fleur et sans formation d'espaces intermédiaires à la zone de réception (10).

3. Agencement selon la revendication 2, **caractérisé en ce que** la zone de réception (10) et la zone d'introduction (11) sont en forme de tronc de cône.

4. Agencement selon l'une des revendications 1 à 3, **caractérisé en ce que** la zone d'introduction (11) présente une longueur de 5 cm à 20 cm, en particulier de 10 cm à 15 cm.

5. Agencement selon l'une des revendications 1 à 4, **caractérisé en ce que** l'élément de couplage (6) est en liaison électriquement conductrice avec un élément conducteur (14) de la pièce de connexion.

6. Agencement selon l'une des revendications 1 à 5, **caractérisé en ce que** l'élément de couplage (6) est vissé à la pièce de connexion (1), notamment à l'élément conducteur (14).

7. Agencement selon l'une des revendications 1 à 6, **caractérisé en ce que** la première électrode (7) et la deuxième électrode (8) sont connectées électriquement l'une à l'autre par un élément résistif, en particulier un élément de résistance (12).

8. Agencement selon l'une des revendications 1 à 7, **caractérisé en ce que** chaque électrode (7, 8) comprend plusieurs éléments de modulation (13) disposés de manière substantiellement circulaire, dans lequel les éléments de modulation (13) des électrodes (7, 8) sont disposés de manière concentrique les uns par rapport aux autres, s'étendent dans des directions opposées et se chevauchent au moins partiellement, à savoir de préférence dans une partie de la zone d'introduction (11) qui s'étend au-delà de la zone de réception (10).

9. Agencement selon l'une des revendications 1 à 8, **caractérisé en ce que** la deuxième électrode (8) s'étend sur au moins 0,5 cm, en particulier sur au moins 1,0 cm, dans la zone de réception (10).

10. Agencement selon l'une des revendications 1 à 9, **caractérisé en ce que** la pièce de connexion (1) comprend un boîtier (15) électriquement isolant, la zone de réception (10) formant une partie du boîtier (15).

11. Dispositif de mesure (3), en particulier capteur de tension électrique, dans lequel
- le dispositif de mesure (3) comprend un élément de couplage (6) pour connecter le dispositif de mesure (3) à une douille de mesure (2) d'une pièce de connexion (1) en forme de T, ainsi qu'un agencement de condensateur avec deux électrodes (7, 8) opposées l'une à l'autre, la première électrode (7) étant disposée sur l'élément de couplage (6) et la deuxième électrode (8) étant disposée sur un élément de mise à la terre (9), et les électrodes (7, 8) comprenant des éléments de modulation (13) en forme de tige ou de doigt, et dans lequel
le dispositif de mesure (3) présente une zone d'introduction (11) avec une longueur de zone d'introduction (11'),
**caractérisé en ce que**
- la zone d'introduction (11) s'étend de l'élément de couplage (6) jusqu'à une marche (18) d'élargissement périphérique, dans laquelle
- les électrodes (7, 8) forment une région de chevauchement (17) qui s'étend également jusqu'à la marche (18), et dans laquelle les électrodes (7, 8) se chevauchent.
